## Europäisches Patentamt
## European Patent Office
## Office européen des brevets

(19)

(11) Numéro de publication : **0 326 441 B1**

(12) **FASCICULE DE BREVET EUROPÉEN**

(45) Date de publication du fascicule du brevet :
**30.09.92 Bulletin 92/40**

(51) Int. Cl.$^5$ : **H05K 9/00,** B29C 55/30,
B29C 63/18

(21) Numéro de dépôt : **89400035.5**

(22) Date de dépôt : **05.01.89**

(54) **Procédé de fabrication d'un joint de blindage électromagnétique, machine pour l'exécution de ce procédé, et joint obtenu à l'aide de ce procédé ou de cette machine.**

(30) Priorité : **13.01.88 FR 8800320**

(43) Date de publication de la demande :
**02.08.89 Bulletin 89/31**

(45) Mention de la délivrance du brevet :
**30.09.92 Bulletin 92/40**

(84) Etats contractants désignés :
**AT BE CH DE ES GB GR IT LI LU NL SE**

(56) Documents cités :
**EP-A- 0 159 733
DE-C- 936 639
FR-A- 2 509 949
GB-A- 1 275 379**

(73) Titulaire : **CAPLATEX SA
Zone Industrielle
F-37600 Loches (FR)**

(72) Inventeur : **Laborie, Claude Fernand
7 rue des Rosiers
F-37600 Perrusson (FR)**

(74) Mandataire : **Durand, Yves Armand Louis et al
CABINET WEINSTEIN 20, Avenue de
Friedland
F-75008 Paris (FR)**

## Description

La présente invention a essentiellement pour objet un procédé de fabrication d'un joint de blindage électromagnétique.

Elle vise également une machine automatique pour la mise en oeuvre de ce procédé, ainsi qu'un joint obtenu par ce procédé ou cette machine.

On a déjà proposé divers types de joints électromagnétiques utilisables pour assurer la continuité électrique de pièces assemblées et pour créer ainsi une barrière au rayonnement électromagnétique.

C'est ainsi que l'on a proposé des joints obtenus par moulage ou extrusion et réalisés en des matériaux élastomères conducteurs assurant une étanchéité au rayonnement électromagnétique et permettant éventuellement la réalisation d'une étanchéité aux fluides lorsque le joint est interposé entre deux pièces. Mais ces joints demeurent très coûteux à fabriquer.

On connaît également des joints réalisés à partir de tricots de fils électriquement conducteurs et qui forment en quelque sorte un boudin de fils métalliques enchevêtrés. De tels joints ne présentent pas une élasticité satisfaisante et peuvent s'écraser facilement, de sorte que les ondes électromagnétiques peuvent passer à travers le joint qui ne constitue donc pas une barrière efficace contre le rayonnement électromagnétique.

On connaît encore des joints de blindage électromagnétique constitués par une âme en matériau élastomère autour de laquelle est tricotée une gaine de fils conducteurs entourant l'âme. La gaine et l'âme du joint forment par conséquent un assemblage lâche et donc peu facile à contrôler et manipuler, sans parler du fait que les deux opérations de vulcanisation de l'âme d'une part, et de tricotage de la gaine en fils conducteurs autour de cette âme d'autre part, demeurent au total longues et coûteuses. Un tel joint est connu du document DE-C-936639

On connait d'après le document G.B.-A-127379 un procédé permettant de couvrir des tuyaux thermoplastiques avec un matériau fibreux.

Ce document décrit un procédé où le matériau fibreux, essentiellement de la fibre de verre, est enroulé autour du tuyau thermoplastique. L'ensemble est alors comprimé dans un manchon avant d'être placé dans une chambre de chauffage. La température de cette chambre de chauffage étant telle que le matériau thermoplastique fond et pénètre dans les interstices entre les fibres du matériau fibreux. Le resultat est un lien solide entre le matériau fibreux et le tuyau thermoplastique.

La présente invention a pour but un joint de blindage électromagnétique peu coûteux à fabriquer et qui possède d'excellentes propriétés au niveau de l'étanchéité aux ondes électromagnétiques et au niveau de son formage, ce qui permet son adaptation et son montage rapide entre deux pièces quelconques à étancher et procure par conséquent une diminution considérable du temps et du coût de montage par rapport aux joints connus.

A cet effet, l'invention a pour objet un procédé de fabrication d'un joint de blindage électromagnétique se composant d'une âme en matériau élastomère et d'au moins une couche de matière textile électriquement conductrice entourant cette âme, caractérisé en ce qu'on effectue en continu le boudinage de l'âme, l'enrobage de cette âme à l'aide de bandes textiles électriquement conductrices et le calibrage de l'âme ainsi enrobée par passage dans au moins une filière procurant outre le calibrage, la solidarisation des bandes de matière textile avec le matériau élastomère de l'âme; et le chauffage de l'âme enrobée, cette dernière étant conformée en un joint de forme appropriée soit après le chauffage précité soit après le calibrage, dans quel cas le joint mis en forme est par la suite chauffé et vulcanisé.

On comprend donc que grâce à ce procédé, non seulement l'opération d'enrobage de l'âme à l'aide de bandes textiles est rapide et peu coûteuse, mais que les bandes textiles seront solidaires du matériau élastomère de l'âme ce qui remédie à tous les inconvénients des joints antérieurs et notamment ceux comportant une âme sur laquelle est simplement tricotée une gaine de fils conducteurs.

Suivant un mode de réalisation de cette invention, le boudinage, l'enrobage et le calibrage précités peuvent être obtenus par co-extrusion de l'âme et des bandes de matière textile.

L'invention vise également une machine pour la mise en oeuvre du procédé répondant aux caractéristiques ci-dessus et du type comprenant au moins une filière d'extrusion d'un matériau élastomère et des moyens d'alimentation d'au moins une bande de matière textile électriquement conductrice pour envelopper le matériau élastomère extrudé, cette machine étant caractérisée en ce qu'elle comprend, en aval des moyens d'alimentation précités, au moins une filière de calibrage de l'ensemble âme élastomère - bandes textiles.

Suivant une autre caractéristique de cette machine, on prévoit un four de cuisson en aval de la filière de calibrage.

Cette invention vise également un joint de blindage électromagnétique obtenu par le procédé et/ou la machine répondant aux caractéristiques ci-dessus, ce joint comportant au moins une couche de matière textile électriquement conductrice intégrée par sa partie en contact avec l'âme, au matériau élastomère de cette âme.

L'âme peut être en tout matériau élastomère approprié plein ou alvéolaire, tandis que la couche de matière textile électriquement conductrice est formée de bandes dont les fils métalliques sont entrelacés de façon serrée ou lâche.

Mais d'autres caractéristiques et avantages de l'invention apparaitront mieux dans la description détaillée qui suit et se réfère aux dessins annexés, donnés uniquement à titre d'exemple, et dans lesquels :

– la figure 1 est une vue très schématique d'une machine permettant la fabrication automatique en continu d'un joint de blindage conforme à cette invention ;

– la figure 2 est une vue en plan d'un exemple de joint réalisé à l'aide du joint fabriqué par la machine de la figure 1 et mis en forme à l'aide d'un outillage approprié ; et

– les figures 3 et 4 sont des vues en coupe d'un joint conforme à cette invention et de section circulaire et rectangulaire respectivement.

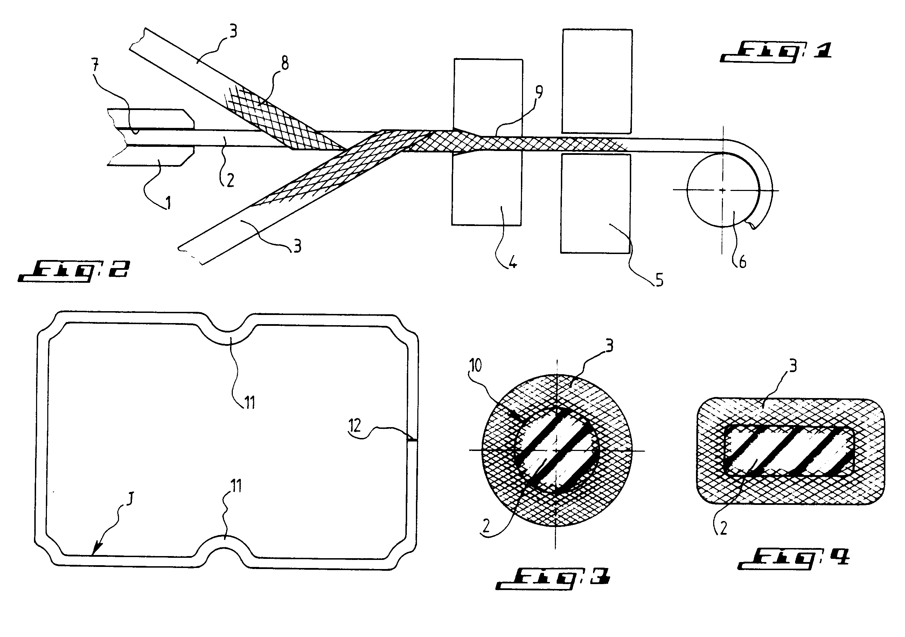

Suivant l'exemple de réalisation illustré sur la figure 1, une machine conforme aux principes de l'invention comprend essentiellement une première filière 1 permettant l'extrusion d'un boudin en élastomère destiné à former l'âme 2 du joint, des moyens d'alimentation (non représentés) d'une ou plusieurs bandes 3 en matière textile électriquement conductrice et qui sont enroulées autour de l'âme 2, une deuxième filière 4 de calibrage de l'ensemble âme 2 - bandes 3, un four de cuisson 5 et une bobine 6 d'enroulement et de stockage du joint sortant de fabrication.

La première filière 1 comporte un orifice 7 de section quelconque permettant l'obtention d'une âme 2, en matériau élastomère également quelconque et présentant par exemple une section circulaire ou rectangulaire, comme on le voit sur les figures 3 et 4.

L'âme boudinée 2 peut être en tout matériau élastomère approprié tel que par exemple polychloroprène, silicone, polyuréthane, élastomère fluoré, épichlorhydrine, ou toute combinaison de ces matériaux en fonction des applications envisagées du joint.

Egalement, l'âme en élastomère 2 peut être pleine ou alvéolaire de façon à réduire les efforts de compression du joint en fonction de l'application envisagée.

L'âme 2 peut encore être obtenue à l'aide d'élastomères thermoplastiques et thermostables pleins ou cellulaires tels que chlorure de polyvinyle, polyamide, polyéthylène, etc... .

Les bandes 3 d'enrobage de l'âme 2 sont constituées par des fils métalliques électriquement conducteurs 8 qui peuvent être entrelacés de façon serrée ou plus ou moins lâche.

Ces fils métalliques conducteurs peuvent être par exemple en nickel, acier inoxydable, cuivre, aluminium, acier revêtu, etc...

Bien entendu, les bandes ou rubans 3 peuvent être réalisés par tout procédé connu tel que par exemple tressage ou tricotage.

Après enrobage de l'âme 2 par les bandes 3, l'ensemble passe comme on le voit bien sur la figure 1, dans l'orifice 9 de la deuxième filière 4, ce qui permet non seulement le calibrage de cet ensemble, mais également la solidarisation des bandes 3 avec le matériau élastomère de l'âme 2, comme on le voit en 10 sur les figures 3 et 4.

Plus précisément, dans la zone repérée 10, on voit qu'il y a interpénétration des parties des bandes 3 en contact avec l'âme 2, et du matériau élastomère constituant cette âme, de sorte que le boudin enrobé sortant de la filière 4 constitue un élément intégral, homogène, souple et présentant toutes les qualités requises d'étanchéité aux ondes électromagnétiques.

Cet élément ou joint, bien que cela ne soit pas obligatoire, peut être chauffé et vulcanisé, en continu, dans l'enceinte ou four 5 avant bobinage sur la bobine 6. L'âme enrobée peut ensuite être conformée en un joint de forme appropriée, que ce joint ait subi une opération de chauffage ou non dans l'enceinte 5. Si l'opération de chauffage n'est pas exécutée, c'est-à-dire lorsque le joint sort du calibrage en 4 et est mis en forme à la suite de ce calibrage, le joint mis en forme pourra être par la suite chauffé et vulcanisé.

On a montré sur la figure 2 un exemple de forme de joint J qui peut être utilisé pour réaliser l'étanchéité aux ondes électromagnétiques entre un carter et son couvercle. Ce joint J peut comporter des parties courbes 11 afin d'éviter le passage des vis de fixation du couvercle sur le carter, et on a montré en 12 les extrémités raboutées, et éventuellement soudées, du joint J réalisé à l'aide d'un outillage approprié après prélèvement d'une longueur de joint sur la bobine 6.

Comme expliqué précédemment, le joint de blindage selon cette invention peut présenter toute forme appropriée telle que circulaire ou polygonale en section transversale (voir figures 3 et 4), et cela en fonction des utilisations envisagées dudit joint.

On a donc réalisé suivant l'invention un joint de blindage électromagnétique pouvant être fabriqué en continu, très avantageux sur le plan du coût de fabrication, de la mise en forme et du temps de montage, et présentant des performances remarquables dues notamment à la solidarisation du textile électriquement conducteur de l'âme du joint et au calibrage.

En outre, un tel joint présente une bonne résistance à la compression, ainsi qu'un comportement et une élasticité très satisfaisants en présence de vibrations d'origine mécanique, ce qui n'était pas le cas avec les joints de blindage antérieurement connus.

Bien entendu, l'invention n'est nullement limitée au mode de réalisation décrit et illustré qui n'a été donné qu'à titre d'exemple.

C'est ainsi que le boudinage, l'enrobage de l'âme et le calibrage pourraient être obtenus par co-extrusion de l'âme et des bandes textiles au lieu de réaliser successivement ces trois opérations comme expliqué précédemment.

## Revendications

1. Procédé de fabrication d'un joint de blindage électromagnétique se composant d'une âme en matériau élastomère (2) et d'au moins une couche de matière textile électriquement conductrice (3) entourant cette âme, dans lequel on effectue en continu : le boudinage de l'âme; l'enrobage de cette âme à l'aide de bandes textiles électriquement conductrices; le calibrage de l'âme ainsi enrobée par passage dans au moins une filière procurant outre le calibrage, la solidarisation des bandes de matière textile avec le matériau élastomère de l'âme; et le chauffage de l'âme enrobée, cette dernière étant conformée en un joint de forme appropriée soit après le chauffage précité soit après le calibrage, dans quel cas le joint mis en forme est par la suite chauffé et vulcanisé.

2. Machine convenant à la mise en oeuvre du procédé selon la revendication 1, et du type comprenant au moins une filière d'extrusion (1) d'un matériau élastomère et des moyens d'alimentation d'au moins une bande (3) de matière textile électriquement conductrice pour envelopper le matériau élastomère extrudé, caractérisée en ce qu'elle comprend, en aval des moyens d'alimentation précités, au moins une filière (4) de calibrage de l'ensemble âme élastomère (2) - bande textile (3).

3. Machine selon la revendication 2, caractérisée par un four de cuisson (5) prévu en aval de la filière de calibrage (4).

4. Joint de blindage électromagnétique susceptible d'être obtenu par le procédé et/ou la machine selon l'une des revendications 1 à 3, et du type comprenant une âme (2) en matériau élastomère enveloppée dans au moins une couche de matière textile électriquement conductrice, caractérisé en ce que la couche de matière textile élastiquement conductrice est intégrée par sa partie en contact avec l'âme (2), au matériau élastomère de cette âme.

5. Joint selon la revendication 4, caractérisé en ce que l'âme (2) est en un matériau élastomère plein ou alvéolaire, tandis que la couche de matière textile est formée de bandes (3) dont les fils métalliques (8) sont entrelacés de façon serrée ou lâche.

## Patentansprüche

1. Verfahren zur Herstellung einer elektromagnetischen Abschirmverbindung bestehend aus einer Seele aus Elastomer-Werkstoff (2) und aus wenigstens einer diese Seele umgebender elektrisch leitender Schicht aus Textilstoff (3), bei welchem man kontinuierlich : das Strangpressen der Seele ; das Einhüllen dieser Seele mit Hilfe von elektrisch leitenden Textilstreifen ; das Kalibrieren der derartig umhüllten Seele durch Führung durch wenigstens eine Düse hindurch, welche ausser dem Kalibrieren, das Anbringen der Textilstoffstreifen an dem elastomerischen Werkstoff der Seele bewirkt ; und das Erwärmen der umhüllten Seele durchführt, wobei diese letztere zu einer Verbindung geeigneter Gestalt entweder nach dem vorgenannten Erwärmen oder nach dem Kalibrieren ausgebildet wird, in welchem Fall die gestaltete Verbindung nachher erhitzt und vulkanisiert wird.

2. Zur Ausführung des Verfahrens nach Anspruch 1 geeignete Maschine, derjenigen Gattung mit wenigstens einer Düse (1) zum Strangpressen eines elastomerischen Werkstoffes und Mitteln zur Zuführung wenigstens eines elektrisch leitenden Streifens (3) aus Textilstoff, um den extrudierten elastomerischen Werkstoff einzuhüllen, dadurch gekennzeichnet, dass sie stromabwärts von den vorgenannten Zufuhrmittel wenigstens eine Düse (4) zum Kalibrieren der Anordnung aus Elastomerseele (2)-Textilstreifen (3) aufweist.

3. Maschine nach Anspruch 2, gekennzeichnet durch einen stromabwärts von der Kalibrierdüse (4) vorgesehenen Backofen (5).

4. Durch das Verfahren und/oder die Maschine nach einem der Ansprüche 1 bis 3 erhaltbare elektromagnetische Abschirmverbindung, derjenigen Gattung, die eine in wenigstens eine Lage aus elektrisch leitenden Textilstoff eingehüllte Seele (2) aus elastomerischen Werkstoff aufweist, dadurch gekennzeichnet, dass die elektrisch leitende Textilstofflage mit ihrem mit der Seele (2) in Berührung stehenden Teil in den elastomerischen Werkstoff dieser Seele eingegliedert ist.

5. Verbindung nach Anspruch 4, dadurch gekennzeichnet, dass die Seele (2) aus einem vollwandigen oder zelligen elastomerischen Werkstoff besteht, während die Schicht aus Textilstoff durch Streifen (3) gebildet wird, deren Metallfäden (8) dicht oder lose verschlungen (46) sind.

## Claims

1. Method of manufacturing an electromagnetic shielding joint consisting of a core of elastomeric material (2) and of at least one layer of electrically conducting textile material (3) surrounding this core, wherein one continuously effects : the extrusion of the core; the wrapping of this core with the assistance of electrically conducting textile strips; the callipering of the core thus wrapped by passage into at least one die providing in addition to the callipering, the fastening of the strips of textile material to the elastomeric material of the core ; and the heating of the wrapped core, the latter being shaped into a joint of suitable shape either after the aforesaid heating or after the callipering, in which case the shaped joint is heated and vulcanized thereafter.

2. Machine suitable for carrying out the method according to claim 1 and of the type comprising at least one die (1) for the extrusion of an elastomeric material and means for feeding at least one strip (3) of electrically conducting textile material to wrap the extruded elastomeric material, characterized in that it comprises downstream of the aforesaid supply means, at least one die (4) for callipering the elastomeric core (2)- textile strip (3) assembly.

3. Machine according to claim 2, characterized by a kilning oven (5) provided downstream of the callipering die (4).

4. Electromagnetic shielding joint susceptible of being obtained by the method and/or the machine according to one of claims 1 to 3 and of the type comprising a core (2) of elastomeric material wrapped in at least one layer of electrically conducting textile material, characterized in that the layer of electrically conducting textile material is integrated with its portion contacting the core (2) to the elastomeric material of this core.

5. Joint according to claim 4, characterized in that the core (2) is made from a solid or alveolate elastomeric material whereas the layer of textile material is formed of strps (3) the metal threads (8) of which are interwoven in a closely fitted or loose manner (46).

Fig. 1

Fig. 2

Fig. 3

Fig. 4